(19) Europäisches Patentamt
European Patent Office
Office européen des brevets

(11) **EP 3 199 662 A1**

(12) **EUROPEAN PATENT APPLICATION**
published in accordance with Art. 153(4) EPC

(43) Date of publication:
**02.08.2017 Bulletin 2017/31**

(51) Int Cl.:
*C23C 14/34* [(2006.01)]   *B22F 1/00* [(2006.01)]
*C22C 9/00* [(2006.01)]   *C22C 28/00* [(2006.01)]
*C22C 32/00* [(2006.01)]

(21) Application number: **15845101.3**

(22) Date of filing: **17.09.2015**

(86) International application number:
**PCT/JP2015/076515**

(87) International publication number:
**WO 2016/047556 (31.03.2016 Gazette 2016/13)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **22.09.2014  JP 2014192151**
**14.09.2015  JP 2015181053**

(71) Applicant: **Mitsubishi Materials Corporation
Chiyoda-ku
Tokyo 100-8117 (JP)**

(72) Inventors:
• **UMEMOTO, Keita**
  **Sanda-shi**
  **Hyogo 669-1339 (JP)**
• **ZHANG, Shoubin**
  **Sanda-shi**
  **Hyogo 669-1339 (JP)**
• **URAYAMA, Koutarou**
  **Sanda-shi**
  **Hyogo 669-1339 (JP)**

(74) Representative: **Hoffmann Eitle
Patent- und Rechtsanwälte PartmbB
Arabellastraße 30
81925 München (DE)**

(54) **SPUTTERING TARGET AND METHOD FOR MANUFACTURING SAME**

(57)    A sputtering target, which has a component composition including: 30.0-67.0 atomic% of Ga; and the Cu balance containing inevitable impurities, wherein the sputtering target is a sintered material having a structure in which θ phases made of Cu-Ga alloy are dispersed in a matrix of the γ phases made of Cu-Ga alloy, is provided.

FIG. 3

θ phase (A)   γ phase (B)

**Description**

Technical Field

The present invention relates to a sputtering target, which is used in the formation of a Cu-In-Ga-Se compound film (hereinafter, abbreviated as the CIGS film, occasionally) for forming the light-absorbing layer of the CIGS thin-film solar cell, and a method of producing the sputtering target.

Priority is claimed on Japanese Patent Application No. 2014-192151, filed September 22,2014 and Japanese Patent Application No. 2015-181053, filed September 14,2015, the contents of which are incorporated herein by reference.

Background Art

Recently, the thin-film solar cell that uses a chalcopyrite-based compound semiconductor film represented by the CIGS film as the light-absorbing layer has been put to practical use. This thin-film solar cell using the compound semiconductor film has a basic structure, in which a Mo electrode layer, which becomes the plus electrode, is formed on a soda-lime glass substrate; a light-absorbing layer made of the CIGS film is formed on the Mo electrode layer; a buffer layer, which is made of ZnS, CdS, or the like, is formed on the light-absorbing layer; and a transparent electrode layer, which becomes the minus electrode, is formed on the buffer layer.

As the method for forming the light-absorbing layer, a sputtering method, which is suitable for deposition on the substrate with large area, is proposed. As the method for forming the CIGS film, the selenization method is adopted. In order to form the light-absorbing layer by the sputtering method, first, an In film is sputtering-deposited by using an In sputtering target. Then, a binary Cu-Ga alloy film is sputtering-deposited on the In film by using a binary Cu-Ga alloy sputtering target. Next, the CIGS film is formed by heat treating the obtained laminated precursor film, which is made of the In film and the binary Cu-Ga alloy film, in an Se atmosphere.

In the selenization method, the order of forming the In film and the binary Cu-Ga alloy film is interchangeable. For example, in the selenization method described in Patent Literature 1 (PTL 1), the Cu-Ln-Ga-Se compound film is formed by: sputter-depositing the Cu-Ga alloy in the thickness of about 500 nm; forming the laminated film, in which the Ln film having the thickness of about 500 nm is sputtered on the film; by heating the laminated film at 500°C in $H_2Se$ gas; and by having Se diffuse into the Cu-Ga-In.

The Cu-Ga alloy sputtering target is essential for this selenization method for the CIGS solar cell using the light-absorbing layer of the Cu-In-Ga-Se compound film (CIGS film) to be produced.

It is known that the band gap changes depending on the ratio between In and Ga for the light absorption wavelength to change in the chalcopyrite-based CIGS film. For example, the light absorption wavelength shifts to the low wavelength side when the Ga ratio is high. Thus, the thin-film solar cell with a $Cu-Ga-Se_2$ compound film free of In is highly expected on application as the top cell in the tandem structure of the CIGS thin-film solar cell. Therefore, there is demand for a Cu-Ga alloy sputtering target containing Ga at high concentration in order to deposit the $Cu-Ga-Se_2$ compound film.

Various proposals have been made as the Cu-Ga alloy sputtering target containing Ga at high concentration (refer Patent Literature 2 (PTL2) and Patent Literature 3 (PTL 3), for example). A sputtering target, which is made of Cu-Ga alloy including multiple phases; and includes 40 weight% or more and 60 weight% or less of Ga and the Cu balance containing inevitable impurities, is disclosed in PTL 2. The multiple phases include a segregation phase containing 80 weight% or more of Ga. In addition, a Cu-Ga alloy sputtering target, which is constituted from a Cu-Ga alloy material with the average composition of: 32 weight% or more and 45 weight% or less of Ga; the balance Cu; inevitable impurities; and inevitable pores, is disclosed in PTL 3. In the Cu-Ga alloy sputtering target disclosed in PTL 3, the Cu-Ga alloy phase including 65 weight% or more of gallium includes at least one phase among the γ1 phase; the γ2 phase; and the γ3 phase.

Citation List

Patent Literature

PTL 1: Japanese Unexamined Patent Application, First Publication No. H10-135495 (A)
PTL 2: Japanese Unexamined Patent Application, First Publication No. 2010-280944 (A)
PTL 3: Japanese Unexamined Patent Application, First Publication No. 2011-241452 (A)

## Summary of Invention

### Technical Problem

In Cu-Ga alloy sputtering targets based on the conventional technology, there are technical problems described below.

The Cu-Ga alloy of the Cu-Ga alloy sputtering target disclosed in PTL 2 is produced by rapidly solidifying the melted raw material after melting the raw material. Specifically, the Cu-Ga alloy (including γ3 phase and ε phase), which includes the segregation phase containing 80 weight% or more of Ga, is produced by passing through the steps of: melting the mixture, which is made of 40 weight% or more and 60 weight% or less of Ga and the Cu balance containing inevitable impurities, by heating in the melting furnace; cooling the melted mixture to 254°C for the γ3 phase of the Cu-Ga alloy to be solidified and formed in the melted mixture; and then, heat treating the water-cooled mold or crucible at a temperature of 200°C or more and less than 254°C after the temperature in the step of cooling reached to 245°C for the ε phase of the Cu-Ga alloy to be precipitated between the γ3 phases.

However, the Cu-Ga alloy sputtering target disclosed in PTL 2 has a technical problem described below. Ga is contained in high concentration and the segregation phase including 80 weight% or more of Ga having poor workability exists in the Cu-Ga alloy sputtering target disclosed in PTL 2. Thus, cracking originated from the segregation phase is likely to occur during machining the sputtering target. In addition, there is the same technical problem in the sputtering target in which alkaline metal such as Na and the like is added to the Cu-Ga alloy.

In the Cu-Ga alloy sputtering target disclosed in PTL 3, the Cu-Ga alloy material, in which the ratio of the volume of the region including copper at less than 47 weight% to the entire volume of the Cu-Ga alloy material is 2% or less, is proposed in order to reduce the segregation phase as described in PTL 2 or the like. In this case, the part excluding the region including copper at less than 47 weight% becomes the region including gallium at 32 weight% to 53 weight% or less. In this case, the γ phase, which shows brittleness when the gallium content is 32 weight% or more, becomes the main phase. Thus, in the Cu-Ga alloy sputtering target disclosed in PTL 3, there is a technical problem that cracking and fracturing are likely to occur during machining in producing the sputtering target.

The present invention is made under the circumstances described above. The purpose of the present invention is to provide a Cu-Ga alloy sputtering target, which is unlikely to be cracked during machining even if it includes Ga at a high concentration, and a method of producing the Cu-Ga alloy sputtering target.

### Solution to Problem

The present invention includes the following aspects in order to solve the above-described problems.

(1) An aspect of the present invention (hereinafter referred as "the sputtering target of the present invention") is a sputtering target having a component composition including: 30.0-67.0 atomic% of Ga; and the Cu balance containing inevitable impurities, wherein the sputtering target is a sintered material having a structure in which θ phases made of Cu-Ga alloy are dispersed in a matrix of the γ phases made of Cu-Ga alloy.

(2) The sputtering target according to the above-described (1), wherein an average crystal grain size of the γ phases is 5.0-50.0 μm.

(3) The sputtering target according to the above-described (1), wherein an average crystal grain size of the θ phases is 5.0-100.0 μm.

(4) The sputtering target according to any one of the above-described (1) to (3), wherein a ratio of an intensity of a main peak among diffraction peaks attributed to the 0 phases to an intensity of a main peak among diffraction peaks attributed to the γ phases is 0.01-10.0.

(5) The sputtering target according to any one of the above-described (1) to (4), further including Na in a range of 0.05-15 atomic%.

(6) The sputtering target according to the above-described (5), wherein the Na is included at least in a form of a Na compound selected from: sodium fluoride; sodium sulfide; and sodium selenide.

(7) Other aspect of the present invention is a method of producing a sputtering target (hereinafter referred as "the method of producing the sputtering target of the present invention"), the method including the step of producing a sintered material by sintering a powder, which is a Cu-Ga alloy powder including 40.0-67.0 atomic% of Ga and the Cu balance containing inevitable impurities; and a ratio of an intensity of a main peak among diffraction peaks attributed to θ phases to an intensity of a main peak among diffraction peaks attributed to γ phases, both of which are obtained from an X-ray diffraction (XRD) pattern, is 0.01-10.0, in non-oxidizing atmosphere or reducing atmosphere: at a sintering temperature of 254°C or more and 450°C or less in a case where the ratio of main peaks is 0.5 or less; or at a sintering temperature lower than 254°C in a case where the ratio of main peaks is more than 0.5.

(8) Other aspect of the present invention is a method of producing a sputtering target, the method including the step of producing a sintered material by sintering a mixed powder in non-oxidizing atmosphere or reducing atmosphere at a temperature of 150-400°C, a raw material powder, which is made of a γ phase of Cu-Ga alloy, and a raw material powder, which is made of a θ phase of Cu-Ga alloy, being mixed in the mixed powder; a mixing ratio of the raw material powder made of the θ phase being 35% or less; the mixed powder having a component composition including 30.0-42.6 atomic% of Ga, the Cu balance containing inevitable impurities; each of the γ phase and the θ phase being represented by a composition formula $Cu_{1-x}Ga_x$; x being 0.295-0.426 in the γ phase; and x being 0.646-0.667 in the θ phase.

Advantageous Effects of Invention

According to the present invention, technical effects described below can be obtained.

According to the sputtering target of the present invention, coarsening of the crystal grains of the γ phase can be suppressed; and occurrence of cracking during machining the target can be reduced, in the Cu-Ga alloy sintered material, since the sintered material, which has the component composition including: 30.0-67.0 atomic% of Ga; and the Cu balance containing inevitable impurities, has the structure in which θ phases made of Cu-Ga alloy are dispersed in the matrix of γ phases made of Cu-Ga alloy.

In addition, according to the method of producing the sputtering target of the present invention, the sintered material having the structure in which the θ phases of the Cu-Ga alloy are dispersed in the matrix of the γ phases of the Cu-Ga alloy can be obtained, since the method includes: the step of producing a sintered material by sintering an atomized powder, which is a Cu-Ga alloy powder including 40.0-67.0 atomic% of Ga, preferably 42.6-67.0 atomic% of Ga, and the Cu balance containing inevitable impurities, in reducing atmosphere at a temperature of 150°C-450 °C, preferably at a temperature of 150°C-400°C; or the step of producing a sintered material by sintering a raw material powder, in which a raw material powder made of a γ phase ($Cu_{1-x}Ga_x$: x=0.295-0.426) and a raw material powder made of a θ phase ($Cu_{1-x}Ga_x$: x=0.646-0.667) are mixed for the component composition of the raw material powder to include 30.0-42.6 atomic% of Ga, and the Cu balance containing inevitable impurities, in non-oxidizing atmosphere or reducing atmosphere at a temperature of 150-400°C. Preferably, the average grain size of the γ phases is 5.0-50.0μm. More preferably, the ratio of the intensity of the main peak among diffraction peaks attributed to the θ phases to the intensity of the main peak among diffraction peaks attributed to the γ phases (0 phase intensity/γ phase intensity) is 0.01-10.0. Diffraction peaks attributed to the θ phases and the γ phases are obtained from the X-ray diffraction (XRD) patterns.

Therefore, in the Cu-Ga alloy sputtering target of the aspect of the present invention including high concentration Ga, cracking is unlikely to occur; and the yield in the target production can be improved. By performing sputtering deposition using this sputtering target, the high Ga concentration-containing light-absorbing layer of the CIGS thin-film solar cell can be deposited; and the usage of the sputtering target can contribute to improvement of the photoelectric conversion efficiency in the light-absorbing layer. Thus, solar cells having high power generation efficiency can be produced.

Brief Description of Drawings

FIG. 1 is the phase diagram of the Cu-Ga alloy.
FIG. 2 is an X-ray diffraction pattern of the sputtering target of an embodiment of the present invention.
FIG. 3 is a photograph of the compositional image of the sputtering target of an embodiment of the present invention.
FIG.4 is an X-ray diffraction pattern of the sputtering target of Comparative Example.
FIG. 5 is a photograph of the compositional image of the sputtering target of Comparative Example.

Description of Embodiments

The sputtering target and the method of producing the sputtering target, which are embodiments of the present invention, are explained below.

The sputtering target of the present embodiment has a component composition including: 30.0-67.0 atomic% of Ga; and the Cu balance containing inevitable impurities. In addition, the sputtering target is a sintered material having a structure in which θ phases made of Cu-Ga alloy are dispersed in a matrix of the γ phases made of Cu-Ga alloy. The structure in which θ phases made of Cu-Ga alloy are dispersed in a matrix of the γ phases made of Cu-Ga alloy means that γ phases and θ phases precipitated during sintering coexist in the sintered material; it is in the state where one phase of the γ phase and the θ phase surrounds the other phase; and it is in the state where each phase is dispersed without being agglomerated on the macro level.

The reason for setting the Ga content to the range of 30.0-67.0 atomic% in the present embodiment is that if the Ga content were less than 30.0 atomic%, the θ phase would almost disappear. In this case, the structure practically becomes a single phase of the γ phase; and the workability of the target deteriorates drastically. On the other hand, if the Ga content exceeded 67.0 atomic%, the pure Ga (melting point is 29.6°C) would be formed even though the θ phase is present. In this case, melting out of Ga occurs by heat in cutting work of the target; and cracking of the target occurs originated from the melted-out Ga.

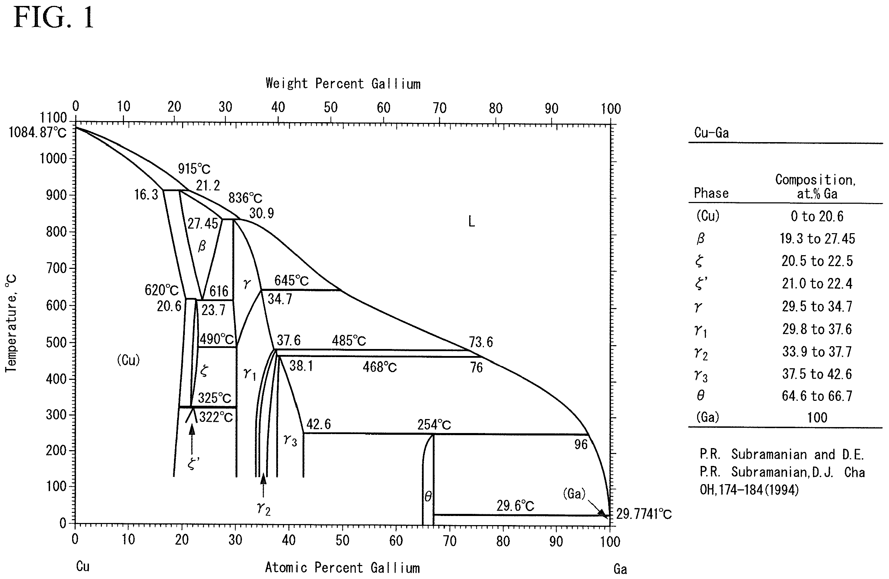

The γ phase and the θ phase in the present embodiment correspond to the γ phase ($Cu_{1-x}Ga_x$: x = 0.295 to 0.426) and the θ phase ($Cu_{1-x}Ga_x$: x = 0.646 to 0.667) in the phase diagram of the Cu-Ga alloy (refer the content in "Cu-Ga system" by P. R. Subramanian and D. E. Laughlin on page 1410 in Binary Alloy Phase Diagrams (2nd. Edition), Copyright 1990 by ASM International(R), ISBN: 0-87170-405-6) shown in FIG. 1 attached to the present specification, respectively. The γ phase in the present embodiment includes γ and γ1-γ3 in the phase diagram shown in FIG. 1.

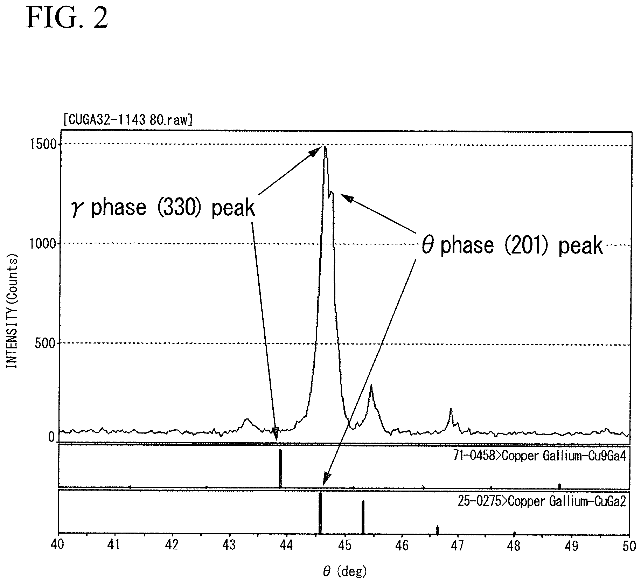

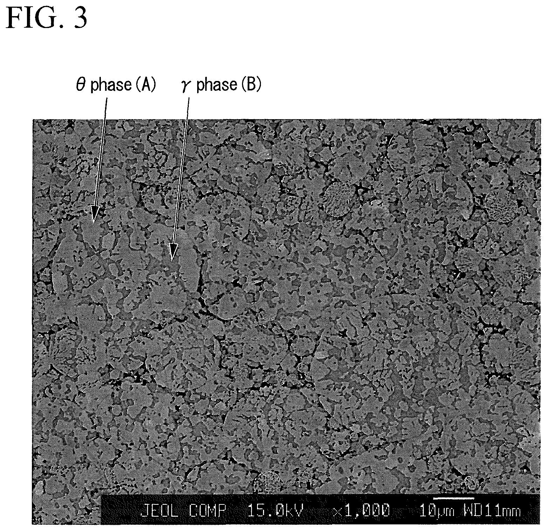

The structure of the sputtering target is explained in reference to FIGS. 2 and 3 by taking the sputtering target of the present embodiment, which is the sputtering target made of the Cu-Ga alloy sintered material, for the representative example. The sputtering target made of the Cu-Ga alloy sintered material was obtained by hot press sintering the atomized powder made of the Cu-Ga alloy having the Ga content of 50.0 atomic% by retaining the powder under the pressure of 50 MPa at the sintering temperature of 165°C for 2 hours, while the Ar gas flew at 10 L/min. FIG. 2 is an X-ray diffraction (XRD) pattern obtained by performing the analysis by the X-ray diffraction (XRD) on the above-described sputtering target. FIG. 3 is a photograph of the compositional image (COMPO image) obtained by performing the electron probe micro analysis (EPMA) on the above-described sputtering target.

As can be seen from the XRD pattern shown in FIG. 2, both of the diffraction peak attributed to the γ phases of the Cu-Ga alloy ($Cu_9Ga_4$ phase) and the diffraction peak attributed to the θ phase of the Cu-Ga alloy ($CuGa_2$ phase) were observed in the above-described sputtering target. The ratio of the intensity of the main peak among diffraction peaks attributed to the θ phases to the intensity of the main peak among diffraction peaks attributed to the γ phases (θ phase intensity/γ phase intensity, referred as "θ phase ratio", occasionally) was 0.80. In addition, it is clear that the two phases to the γ phase and the 0 phase exist in the state where they were dispersed each other in the sputtering target. In addition, the whitest part indicates the region having a relatively high Ga content in the photograph of the COMPO image shown in FIG. 3. As indicated by arrows in FIG. 3, the light gray area and the dark gray area indicate the θ phase and the γ phase, respectively.

As explained above, it was demonstrated that the above-described sputtering target had the crystal structure in which the θ phases with a relatively high Ga content exist in the matrix of the γ phases. Even in the case where Na or K was added to the sputtering target, the crystal structure of the sputtering target had the two-phase-coexisting structure of the γ phase and the θ phase.

The reason for the two phases of the γ phase and the θ phase to coexist in the crystal structure of the sputtering target is that the ratio of the intensity of the main peak among diffraction peaks attributed to the θ phases to the intensity of the main peak among diffraction peaks attributed to the γ phases, both of which are obtained from the X-ray diffraction (XRD) pattern of the raw material Cu-Ga alloy powder, is 0.01 to 10.0. In the case where the θ phase in the raw material Cu-Ga alloy powder is low, specifically in the case where the θ phase ratio is 0.5 or less, by setting the sintering temperature at 254°C or more, the liquid phase of the θ phase appears from the Cu-Ga alloy powder during sintering. Thus, sintering becomes so called the liquid phase sintering; and the sintered material is densified easily. Therefore, the sputtering target made of the sintered material with a high density can be obtained even in the powder sintering by the low temperature hot pressing. In the cooling process of the sintered material, the θ phases precipitate around 254°C. In the case where the θ phase in the raw material Cu-Ga alloy powder is high, specifically, in the case where the θ phase ratio exceeds 0.5, by setting the sintering temperature at less than 254°C, the liquid phase does not precipitate form the θ phase. Thus, the θ phases in the raw material Cu-Ga alloy are retained. If the sintering temperature were set to 254°C or more in this setup instead, it would become hard to retain the shape of the sintered material since too much liquid phase is formed from the θ phase.

In addition, in the case where the θ phase ratio exceeds 0.5, in other words, in the case where the raw material powder made of the θ phase ($Cu_{1-x}Ga_x$: x = 0.646 to 0.667) is used, by using a mixed raw material powder in which the second Cu-Ga alloy raw material powder, the Cu-Ga alloy raw material of which is free of the θ phase meaning being made of the γ phase ($Cu_{1-x}Ga_x$: x = 0.295 to 0.426), is mixed to the raw material powder made of the θ phase in such a way that the component composition of the mixed raw material powder includes 30.0-42.6 atomic% of Ga and the Cu balance containing inevitable impurities, Ga diffuses from the Cu-Ga alloy raw material powder made of the θ phase to the Cu-Ga alloy raw material powder made of the γ phase. Thus, the precipitation of the liquid phase of Ga can be suppressed; and the sintered material can be obtained even in sintering at 254C or more. It is preferable that mixing ratio of the Cu-Ga alloy material powder, in which the θ phase ratio exceeds 0.5, is 30% or less. If the mixing ratio exceeded 30%, it would be hard to retain the shape of the sintered material due to the excessive amount of the liquid phase from the θ phase even if Ga diffuses from the Cu-Ga alloy raw material powder made of the θ phase to the Cu-Ga alloy raw material powder made of the γ phase.

The advantage of the two phases of the γ phase and the θ phase being coexisting is that coarsening of the crystal grains of the γ phase is suppressed by the existence of the θ phase; and it becomes hard for the sputtering target to be cracked during machining of the sputtering target by miniaturization of the average crystal grain size in the target structure.

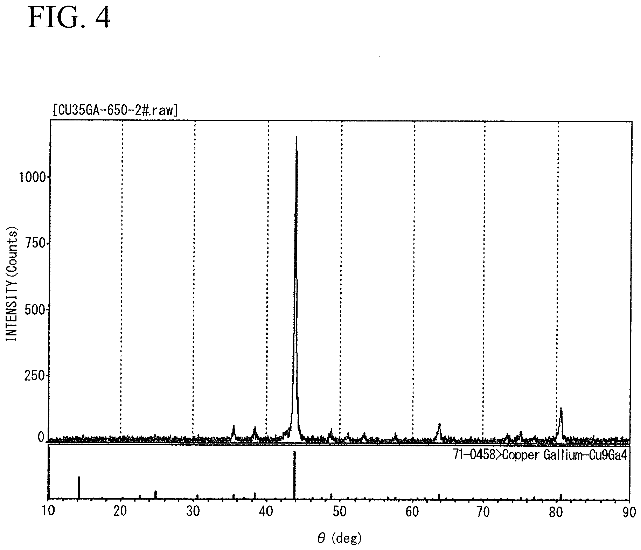

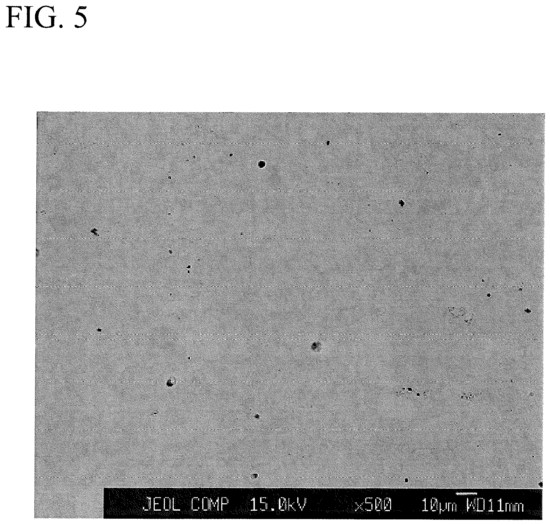

As an example for comparing to the above-described sputtering target of the present embodiment, the Cu-Ga alloy sputtering target was obtained by hot press sintering the atomized powder made of the Cu-Ga alloy having the Ga content of 33.0 atomic% by retaining the powder under the pressure of 60 MPa at the sintering temperature of 700°C for 2 hours, while the Ar gas flew at 10 L/min. The obtained sputtering target was subjected to the analysis by the X-ray diffraction (XRD). The measurement results are shown on the XRD pattern in FIG. 4. In addition, the electron probe micro analysis (EPMA) was performed on the sputtering target and the obtained photograph of the compositional image (COMPO image) is shown in FIG. 5. In the XRD pattern in FIG. 4, only the diffraction peaks attributed to the γ phases of the Cu-Ga alloy are observed. In the photograph of the COMPO image in FIG. 5, the entire image is in gray; and there is almost no parches of dark and light gray spots. The black spots in the image are pores. Because of these, it is demonstrated that the main phase of the matrix is formed from the single phase of the γ phase; and there is no θ phase including relatively high content of Ga, in sintered material of this sputtering target based on this comparative example.

In addition, it is preferable that: the average crystal grain size of the γ phases is 5.0-50.0 $\mu$m; the average crystal grain size of the θ phase is 5.0-100.0 $\mu$m; and the ratio of the intensity of the main peak among diffraction peaks attributed to the θ phases to the intensity of the main peak among diffraction peaks attributed to the γ phases (0 phase intensity/γ phase intensity), both of which are obtained from the X-ray diffraction (XRD) pattern, is in the range of 0.01-10.0, in the sputtering target of the present embodiment.

When the average crystal grain size of the γ phases exceeds 50.0 $\mu$m and the average crystal grain size of the θ phase exceeds 100.0 $\mu$m in the sputtering target of the present embodiment, chipping (cracking, fracturing, and the like) is likely to occur during machining after sputtering target production. When the θ phase ratio, which expresses that the γ phase and the θ phase coexist in the sputtering target, is set in the range of 0.01-10.0, coarsening of the γ phases is suppressed by the existence of the θ phase. Thus, the sputtering target is unlikely to be cracked during machining of the sputtering target.

In addition, 0.05-15 atomic % of Na may be included in the sputtering target in order to improve the photoelectric conversion efficiency since the sputtering target of the present embodiment can be utilized for formation of the CIGS film, which becomes the light-absorbing layer of the solar cell. Furthermore, the Na may be included at least in one form of Na compounds of sodium fluoride, sodium sulfide, and sodium selenide. Alternatively, 0.05-15 atomic% of K may be included in the sputtering target instead of Na; and the K may be included at least in one form of K compounds of potassium fluoride, potassium chloride, potassium bromide, potassium iodide, potassium sulfide, potassium selenide, and potassium niobate. In addition, Na and K may be included at the same time. In this case, the total of Na and K is set to 0.05-15 atomic%.

Next, the method of producing the sputtering target of the present embodiment is explained.

The method of producing the sputtering target of the present embodiment is a method for producing the sputtering target of the present embodiment. The method includes the step of producing a sintered material by sintering a powder, which is a Cu-Ga alloy powder including 40.0-67.0 atomic% of Ga and the Cu balance containing inevitable impurities; and a ratio of an intensity of a main peak among diffraction peaks attributed to θ phases to an intensity of a main peak among diffraction peaks attributed to γ phases (θ phase intensity/γ phase intensity), both of which are obtained from an X-ray diffraction (XRD) pattern, is 0.01-10.0, in non-oxidizing atmosphere or reducing atmosphere: at a sintering temperature of 254°C or more and 450°C or less in a case where the ratio of main peaks is 0.5 or less; or at a sintering temperature lower than 254°C in a case where the ratio of main peaks is more than 0.5.

Adjustment of the crystal grain size in the sintered material is made easier by using the Cu-Ga alloy powder in the method of producing the sputtering target. In addition, the structure, in which the θ phases of the Cu-Ga alloy are dispersed in the matrix of the γ phases of the Cu-Ga alloy, is obtained in the sintered material; and the average crystal grain size of the γ phases is set to 50.0 $\mu$m or less, because: the ratio of the intensity of the main peak among diffraction peaks attributed to θ phases to the intensity of the main peak among diffraction peaks attributed to γ phases (θ phase intensity/γ phase intensity), both of which are obtained from an X-ray diffraction (XRD) pattern, is 0.01-10.0; and the sintering temperature for obtaining the sintered material related to the sputtering target is set in the range of 150-450°C.

In addition, the other method of producing the sputtering target of the present embodiment is a method for producing the above-described sputtering target. The method includes the step of producing a sintered material by sintering a mixed powder in non-oxidizing atmosphere or reducing atmosphere at a temperature of 150-400°C, a raw material powder, which is made of a γ phase of Cu-Ga alloy ($Cu_{1-x}Ga_x$: x = 0.295-0.426), and a raw material powder, which is made of a θ phase of Cu-Ga alloy ($Cu_{1-x}Ga_x$: x = 0.646-0.667), being mixed in the mixed powder; and the mixed powder having a component composition including 30.0-42.6 atomic% of Ga, the Cu balance containing inevitable impurities.

In the method of producing the sputtering target, by using the raw material powder of γ phase ($Cu_{1-x}Ga_x$: x = 0.295-0.426) and the raw material powder of θ phase ($Cu_{1-x}Ga_x$: x = 0.646-0.667), the structure, in which the θ phases of the Cu-Ga alloy are dispersed in the matrix of the γ phases of the Cu-Ga alloy, is obtained; and the average crystal grain size of the γ phases is set to 50.0 μm or less, even in the composition containing 30.0-42.6 atomic% of Ga in the sintered material.

For example, the procedure for producing the Cu-Ga binary sputtering target of the present embodiment includes the steps of: producing the raw material powder by the gas atomizing method after weighting Cu metal cramps and Ga metal cramps in predetermined amounts as alloy powders and melting each of them in a crucible; mixing the raw material powders and if necessary the Na compound raw material powder and the K compound material powder in non-oxidizing atmosphere; sintering the raw material powder at a low temperature in non-oxidizing atmosphere or reducing atmosphere; and cutting the surface of the sintered material obtained in the step of sintering.

In the step of producing the raw material powder, a carbon crucible is filled with each of Cu metal cramps and Ga metal cramps in predetermined composition ratios; and the Cu-Ga alloy atomized powder, which is the raw material powder, is prepared by the gas atomized method by Ar gas.

In the step of sintering at a low temperature, one of hot-pressing, hot isotropic pressure sintering and pressureless sintering is used; and the retention temperature in sintering is set in the range of 150-450°C. The non-oxidizing atmosphere is atmosphere free of oxygen, such as Ar atmosphere, vacuum atmosphere, and the like. The reducing atmosphere is atmosphere including reducing gas such as $H_2$, CO, and the like.

In the step of cutting the surface of the sintered material, the sputtering target having the diameter of 50 mm and the thickness of 6 mm is produced by machining the surface part and outer periphery part of the obtained sintered material on a lathe.

Next, the sputtering target after machining is bonded on the backing plate made of Cu, sus (stainless), or other metal (for example, Mo) by using In as solder to be used in sputtering.

In storing the machined target, it is preferable that the entire target is sealed in vacuum packing or inert gas replacement packing in order to avoid oxidation and moisture absorption.

The sputtering target produced as described above is installed on the DC magnetron sputtering apparatus using Ar gas as sputter gas. In the direct current (DC) sputtering at this time, a pulse DC power supply applying pulse voltage or a DC power supply without pulse can be used.

By following the above-described procedure, the θ phases are dispersed in the matrix of the γ phases of the sintered material of Cu-Ga alloy in the present embodiment. The reason why the two phases of the γ phase and the θ phase coexist is that the ratio of the intensity of the main peak among diffraction peaks attributed to 8 phases to the intensity of the main peak among diffraction peaks attributed to γ phases (θ phase intensity/γ phase intensity), both of which are obtained from an X-ray diffraction (XRD) pattern, is 0.01-10.0. In the case where the θ phase in the raw material Cu-Ga alloy powder is low, specifically in the case where the θ phase ratio is 0.5 or less, by setting the sintering temperature at 254°C or more, the liquid phase of the θ phase appears from the Cu-Ga alloy powder during sintering. Thus, sintering becomes so called the liquid phase sintering; and the sintered material is densified easily. Therefore, the sintered material with a high density can be obtained even in the powder sintering by the low temperature hot pressing. In the cooling process of the sintered material, the θ phases precipitate around 254°C. In the case where the θ phase in the raw material Cu-Ga alloy powder is high, specifically, in the case where the θ phase ratio exceeds 0.5, by setting the sintering temperature at less than 254°C, the liquid phase does not precipitate form the θ phase. Thus, the θ phases in the raw material Cu-Ga alloy are retained. If the sintering temperature were set to 254°C or more in this setup instead, it would become hard to retain the shape of the sintered material since too much liquid phase is formed from the θ phase. Based on the phase diagram of the Cu-Ga alloy in "Binary Alloy Phase Diagrams (2nd. Edition)", it is foreseen that the phase separation occurs certainly in the case where the atomic ratio of Ga is 42.6% or more. In addition, even in the case where the atomic ratio of Ga is 30.0-42.6%, the structure in which the θ phases are dispersed in the matrix of the γ phases of the sintered material of Cu-Ga alloy can be obtained by using the raw material powder made of the γ phase of Cu-Ga alloy ($Cu_{1-x}Ga_x$: x = 0.295-0.426), and the raw material powder made of a θ phase of Cu-Ga alloy ($Cu_{1-x}Ga_x$: x = 0.646-0.667) as the raw material powders. The advantage of the two phases being coexisting is that coarsening of the crystal grains of the γ phases is suppressed by the existence of the θ phase; and the average grain size in the target structure becomes small, making it hard for the sputtering target to be cracked during machining of the sputtering target.

Next, the sputtering target related to the present embodiment, and the method of producing the sputtering target, are explained specifically by Examples and Comparative Examples.

Examples

First, the Cu metal cramps and the Ga metal cramps, both of which had the purity of 4N grade (purity: 99.99%), were prepared. They were weighted for the total weight to be 1200g with the component compositions shown in Table 1. After filling the carbon crucible with each of them and melting the cramps in the carbon crucible, the raw material powder A and the raw material powder B, in both of which the Ga contents were adjusted, were prepared by the gas atomizing method by Ar gas. These raw material powders were sieved through 125 μm to be classified. The gas atomizing condition was: 1000-1200°C of the temperature in melting; 28kgf/cm$^2$ of the ejection gas pressure; and 1.5 mm of the nozzle diameter.

In Examples 1, 3, 5, 9, 15, and 16, the Cu-Ga raw material powders were obtained by using the raw material powder A, which was produced by the above-described gas atomizing method (the mixing ratio: 100%) and had the structure in which the θ phases ($Cu_{1-x}Ga_x$: x = 0.646-0.667) were dispersed in the matrix of the γ phase in the θ phase ratios shown in Table 1.

In Examples 2, 4, 10, and 13, the Cu-Ga raw material powders were obtained: by weighting the raw material powder A, which had the θ phase ratios shown in Table 1 and had the structure in which the θ phases were dispersed in the matrix of the γ phases, and the raw material powder B made of the single phase the γ phase ($Cu_{1-x}Ga_x$: x = 0.295-0.426), in the mixing ratios shown in Table 1; and then by mixing them by a rocking mixer. The mixing conditions by the rocking mixer were: 72 rpm of the rotation speed; and 30 minutes of the mixing time.

In Examples 6 and 7, the raw material powders were obtained: by weighting the raw material powder A and the Na additives shown in Table 2 in the mixing ratios of the raw material powder A and the Na additives shown in Table 1 and 2, respectively; and then by them by a rocking mixer. In Examples 8 and 11, the raw material powders were obtained: by weighting the raw material powders A and B in the mixing ratios shown in Table 1; by mixing them by the rocking mixer to obtain the mixture; by adding the Na additives shown in Table 2 to the mixture in the mixing ratios shown in Table 2; and then by mixing them by the rocking mixer. As the Na additives, the Na compound powders having the purity of 3N (purity: 99.9%) were used.

In Examples 14, 19-23, the raw material powder were obtained: by weighting the raw material powders A and the K additives shown in Table 2 in the mixing ratios of the raw material powder A and the K additives shown in Table 1 and 2, respectively; and by mixing them by the rocking mixer.

In Example 17, the raw material powder was obtained: by weighting the raw material powder A, the raw material powder B, and the K additive in the mixing ratios of the raw material powders A, B, and the K additive shown in Table 1 and 2, respectively; and then by mixing them by the rocking mixer.

In Example 18, the raw material powder was obtained: by weighting the raw material powder A, the Na and K additives shown in Table 2 in the mixing ratios of the raw material powder A and the Na and K additives shown in Table 1 and 2, respectively; and then by mixing them by the rocking mixer.

Results of the component composition analysis on the Cu-Ga raw material powders obtained in the mixing procedures described above are shown in the column "Composition of Cu-Ga raw material" in Table 2. In the column of "Cu" in Table 2, it is shown as "balance." F, Cl, Br, I, S, Se, Nb, and O are excluded from this "balance."

Next, 100g of each of the produced raw material powders was weighted, and sintered in the sintering conditions shown in Table 3 to obtain Cu-Ga alloy sintered materials. The surface part and the outer peripheral part of the obtained sintered materials were machined on a lathe to produce the sputtering targets of Examples 1-23 (Exs. 1-23) having the diameter of 50 mm and the thickness of 6 mm. The way to obtain the θ phase is explained in detail later, but essentially it can be obtained from $I_{obs}$(θ phase)/$I_{obs}$(γ phase) wherein $I_{obs}$(θ phase) is the measure peak intensity of the θ phase (102) plane and $I_{obs}$(γ phase) is the measure peak intensity of the γ phase (330) plane. Example 14 was a representative example in the case where the K compound was added instead of the Na compound. As in the case where the Na compound was added, the raw material powder in Example 14 was obtained by mixing the Cu-Ga raw material powder obtained in advance and the K compound in the mixing ratio shown in Table 2 in mixing by the rocking mixer. Similarly, in Example 18, the Na compound (NaF) and the K compound (KCl) were prepared and mixed with the Cu-Ga raw material powder obtained in advance.

[Comparative Examples]

On the other hand, sintered materials were obtained by performing sintering in conditions deviated from the ranges of the above-described Examples of the present invention as comparative examples; and Cu-Ga alloy sputtering targets of Comparative Examples 1-4 (C. Exs. 1-4) were produced.

In Comparative Example 1, the Ga content in the raw material powder A was less compared to the case in Examples of the present invention; and the θ phase ratio was low. In addition, hot pressing was performed at a high temperature beyond the temperature range in the method of producing the sputtering target of the present invention. In Comparative Example 2, the Ga content in the raw material powder A was excessive compared to the case in Examples of the present invention; and the γ phase was absent. In Comparative Example 3, although the raw material powders A and B were used, the mixing ratio of the raw material powder B was excessive; and the Ga content in the Cu-Ga alloy raw material powder was less compared to the case in Examples of the present invention. In Comparative Example 4, although the raw material powders A and B were used, the mixing ratio of the raw material powder A was excessive.

[Table 1]

| | | Raw material powder A | | | | | Raw material powder B | | | |
|---|---|---|---|---|---|---|---|---|---|---|
| | | Composition | | Ave. grain size (μm) | θ phase ratio | Mixing ratio (%) | Composition | | Ave. grain size (μm) | Mixing ratio (%) |
| | | Ga (at%) | Cu | | | | Ga (at%) | Cu | | |
| Ex. 1 | | 50.0 | balance | 5.3 | 0.91 | 100.0 | | | | |
| Ex. 2 | | 66.0 | balance | 23.5 | 1.34 | 10.3 | 37.0 | balance | 12.6 | 89.7 |
| Ex. 3 | | 55.0 | balance | 4.4 | 1.78 | 100.0 | | | | |
| Ex. 4 | | 66.0 | balance | 7.5 | 1.25 | 6.1 | 33.0 | balance | 7.2 | 93.9 |
| Ex. 5 | | 65.0 | balance | 8.7 | 9.99 | 100.0 | | | | |
| Ex. 6 | | 55.0 | balance | 4.8 | 1.54 | 99.2 | | | | |
| Ex. 7 | | 50.0 | balance | 6.6 | 0.91 | 98.2 | | | | |
| Ex. 8 | | 66.0 | balance | 7.5 | 1.25 | 13.1 | 35.0 | balance | 11.9 | 67.9 |
| Ex. 9 | | 50.0 | balance | 45.3 | 0.75 | 100.0 | | | | |
| Ex. 10 | | 66.0 | balance | 23.5 | 1.25 | 8.3 | 30.0 | balance | 25.8 | 91.7 |
| Ex. 11 | | 66.0 | balance | 15.6 | 1.34 | 27.3 | 30.0 | balance | 23.4 | 70.9 |
| Ex. 12 | | 66.0 | balance | 4.5 | 1.21 | 27.8 | 30.0 | balance | 20.6 | 72.2 |
| Ex. 13 | | 66.0 | balance | 103.1 | 1.10 | 27.8 | 30.0 | balance | 20.6 | 72.2 |
| Ex. 14 | | 50.0 | balance | 45.3 | 0.82 | 98.5 | | | | |
| Ex. 15 | | 50.0 | balance | 254.0 | 0.88 | 100.0 | | | | |
| Ex. 16 | | 40.0 | balance | 32.9 | 0.12 | 100.0 | | | | |
| Ex. 17 | | 66.0 | balance | 15.6 | 1.34 | 31.4 | 35 | balance | 11.9 | 66.0 |
| Ex. 18 | | 50.0 | balance | 45.3 | 0.82 | 97.3 | | | | |
| Ex. 19 | | 55.0 | balance | 4.8 | 1.54 | 93.9 | | | | |
| Ex. 20 | | 50.0 | balance | 45.3 | 0.75 | 95.8 | | | | |
| Ex. 21 | | 55.0 | balance | 4.8 | 1.54 | 95.8 | | | | |
| Ex. 22 | | 50.0 | balance | 5.3 | 0.91 | 99.0 | | | | |
| Ex. 23 | | 50.0 | balance | 45.3 | 0.75 | 95.4 | | | | |
| C. Ex. 1 | | 33.0 | balance | 8.5 | - | 100.0 | | | | |

(continued)

| | Raw material powder A | | | | | Raw material powder B | | | |
|---|---|---|---|---|---|---|---|---|---|
| | Composition | | Ave. grain size (μm) | θ phase ratio | Mixing ratio (%) | Composition | | Ave. grain size (μm) | Mixing ratio (%) |
| | Ga (at%) | Cu | | | | Ga (at%) | Cu | | |
| C. Ex. 2 | 70.0 | balance | 6.6 | No γ phase | 100.0 | | | | |
| C. Ex. 3 | 66.0 | balance | 20.7 | 1.21 | 1.4 | 29.0 | balance | 15.8 | 98.6 |
| C. Ex. 4 | 66.0 | balance | 23.5 | 1.34 | 32.3 | 35.0 | balance | 23.4 | 67.7 |

[Table 2]

| | Na additive | | K additive | | Composition of Cu-Ga alloy raw material powder | | | |
|---|---|---|---|---|---|---|---|---|
| | Compound | Mixing ratio (%) | Compound | Mixing ratio (%) | Ga (at%) | Na (at%) | K (at%) | Cu |
| Ex. 1 | - | - | - | - | 50.0 | - | - | balance |
| Ex. 2 | - | - | - | - | 40.0 | - | - | balance |
| Ex. 3 | - | - | - | - | 55.0 | - | - | balance |
| Ex. 4 | - | - | - | - | 35.0 | - | - | balance |
| Ex. 5 | - | - | - | - | 65.0 | - | - | balance |
| Ex. 6 | $Na_2S$ | 0.8 | - | - | 54.5 | 0.5 | - | balance |
| Ex. 7 | NaF | 1.8 | - | - | 49.1 | 1.0 | - | balance |
| Ex. 8 | $Na_2Se$ | 19.0 | - | - | 32.4 | 7.0 | - | balance |
| Ex. 9 | - | - | - | - | 50.0 | - | - | balance |
| Ex. 10 | - | - | - | - | 33.0 | - | - | balance |
| Ex. 11 | NaF | 1.8 | - | - | 40.0 | 1.0 | - | balance |
| Ex. 12 | - | - | - | - | 40.0 | - | - | balance |
| Ex. 13 | - | - | - | - | 40.0 | - | - | balance |
| Ex. 14 | - | - | KF | 1.5 | 49.3 | - | 1.0 | balance |
| Ex. 15 | - | - | - | - | 50.0 | - | - | balance |
| Ex. 16 | - | - | - | - | 40.0 | - | - | balance |
| Ex. 17 | - | - | KCl | 2.6 | 43.8 | - | 5.0 | balance |
| Ex. 18 | NaF | 1.4 | KCl | 1.3 | 48.7 | 2.5 | 2.5 | balance |
| Ex. 19 | - | - | KBr | 6.1 | 51.7 | - | 2.0 | balance |
| Ex. 20 | - | - | KI | 4.2 | 47.9 | - | 1.0 | balance |
| Ex. 21 | - | - | $K_2S$ | 4.2 | 52.7 | - | 3.0 | balance |
| Ex. 22 | - | - | $K_2Se$ | 1.0 | 49.5 | - | 0.5 | balance |
| Ex. 23 | - | - | $KNbO_3$ | 4.6 | 47.7 | - | 1.0 | balance |
| C. Ex. 1 | - | - | - | - | 33.0 | - | - | balance |
| C. Ex. 2 | - | - | - | - | 70.0 | - | - | balance |

(continued)

|  | Na additive | | K additive | | Composition of Cu-Ga alloy raw material powder | | | |
|---|---|---|---|---|---|---|---|---|
|  | Compound | Mixing ratio (%) | Compound | Mixing ratio (%) | Ga (at%) | Na (at%) | K (at%) | Cu |
| C. Ex. 3 | - | - | - | - | 29.5 | - | - | balance |
| C. Ex. 4 | - | - | - | - | 45.0 | - | - | balance |

[Table 3]

|  |  | Sintering conditions | | | | |
|---|---|---|---|---|---|---|
|  |  | Sintering method | Atmosphere | Temperature (°C) | Retention time (hours) | Pressure (MPa) |
|  | Ex. 1 | Hot pressing | Ar | 165 | 2 | 50 |
|  | Ex. 2 | HIP | Vacuum | 350 | 1 | 60 |
|  | Ex. 3 | Hot pressing | Ar | 160 | 2 | 45 |
|  | Ex. 4 | Pressureless sintering | $H_2$ | 400 | 5 | - |
|  | Ex. 5 | HIP | Vacuum | 150 | 1 | 55 |
|  | Ex. 6 | Hot pressing | Ar | 160 | 2 | 60 |
|  | Ex. 7 | Pressureless sintering | $H_2$ | 165 | 5 | - |
|  | Ex. 8 | HIP | Vacuum | 340 | 1 | 45 |
|  | Ex. 9 | Hot pressing | Vacuum | 160 | 1 | 60 |
|  | Ex. 10 | HIP | Vacuum | 350 | 3 | 60 |
|  | Ex. 11 | Hot pressing | Vacuum | 340 | 2 | 30 |
|  | Ex. 12 | Hot pressing | Vacuum | 350 | 2 | 35 |
|  | Ex. 13 | Hot pressing | Vacuum | 340 | 2 | 35 |
|  | Ex. 14 | Hot pressing | Vacuum | 160 | 2 | 60 |
|  | Ex. 15 | Hot pressing | Ar | 160 | 2 | 55 |
|  | Ex. 16 | Hot pressing | Ar | 450 | 2 | 50 |
|  | Ex. 17 | Hot pressing | Vacuum | 160 | 3 | 60 |
|  | Ex. 18 | Hot pressing | Ar | 160 | 2 | 55 |
|  | Ex. 19 | Hot pressing | Vacuum | 165 | 2 | 50 |
|  | Ex. 20 | Hot pressing | Ar | 160 | 1 | 55 |
|  | Ex. 21 | HIP | Vacuum | 150 | 2 | 60 |
|  | Ex. 22 | Hot pressing | Ar | 160 | 1.5 | 55 |
|  | Ex. 23 | Hot pressing | Vacuum | 165 | 2 | 60 |
|  | C. Ex. 1 | Hot pressing | Ar | 700 | 2 | 60 |
|  | C. Ex. 2 | HIP | Vacuum | 150 | 1 | 50 |
|  | C. Ex. 3 | Hot pressing | Vacuum | 380 | l | 60 |
|  | C. Ex. 4 | Hot pressing | Vacuum | 400 | 1 | 60 |

Target workability of the sputtering targets of Examples 1-23 of the present invention and Comparative Examples 1-4 produced as described above was investigated by: measuring the density of the sintered materials, the average crystal grain sizes of the γ phase and the θ phase in the Cu-Ga alloy, the θ phase ratio, and the surface roughness; and observing the structure of the targets and occurrence of chipping in cutting. In Comparative Example 2, Ga was melted out in machining and cracking occurred. In Comparative Example 4, the θ phase was melted out in sintering; and the sintered material was not formed properly. Thus, each of evaluations was not performed in Comparative Examples 2 and 4

[Measurement of density of the sintered material]

On the sputtering targets of the above-described Examples 1-23 of the present invention and Comparative Examples 1 and 3, densities of the sintered materials were measured. The dimensional density (g/cm$^3$) was obtained by using the volume and the weight calculated from the dimension of each sintered material.

The measurement results are shown in the column "Density (g/cm$^3$)" in Table 4.

[Measurement of the average crystal grain sizes of the γ and θ phases]

On the sputtering targets of the above-described Examples 1-23 of the present invention and Comparative Examples 1 and 3, the average crystal grain sizes of the γ phase and the θ phase of the Cu-Ga alloy were measured.

In this measurement, the sample surfaces cut out from the sputtering targets were polished to mirror surface, and subjected to etching by the etching solution made of nitric acid and pure water. Then, five compositional images (COMPO images) were taken in the magnification range of 50-1000 times, in which the crystal grain boundaries were distinguished in EPMA. Then, obtained images were converted to binary images by converting the taken images to black and white images by using a commercially available image processing software such as WinRoof (manufactured by Mitani Co.) and the like, and using a threshold value. Then, the maximum circumcircles were drawn on arbitrary selected 20 crystal grains of the γ phase (or the θ phase) in the image obtained by showing the γ phase (or the θ phase) in black. The average of the diameter in the image was defined as the average crystal grain size in the image. Then, the average value of the averages from five images was defined as the average crystal grain size.

The measurement results are shown in the columns "Ave. crystal grain size of the γ phase" and "Ave. crystal grain size of the γ phase" in Table 4.

[θ phase ratio]

On the sputtering targets of the above-described Examples 1-23 of the present invention and Comparative Examples 1 and 3, the intensity of the main peak among diffraction peaks attributed to the γ phases and the intensity of the main peak among diffraction peaks attributed to the θ phase, both of which were obtained from X-ray diffraction (XRD) pattern, were measured. By calculating the ratio of the intensity of the main peak attributed to the θ phases to the intensity of the main peak attributed to the γ phases, the θ phase ratio was obtained. The peak intensity of the θ phase (102) plane and the peak intensity of the γ phase (330) plane were regarded as the intensity of the main peak attributed to the θ phase and the intensity of the main peak attributed to the γ phases, respectively.

The XRD patterns were measured after wet-polishing the sputter surfaces of the sputtering targets by the SiC-Paper (grit 180) and drying. The apparatus and measurement conditions used in this analysis are shown below.

Apparatus: RINT-Ultima/PC manufacture by RIGAKU Co. Ltd.
Tube: Cu
Tube voltage: 40 kV
Tube current: 40 mA
Scanning range (2θ): 20°-120°
Slit size: Divergence (DS) 2/3 degree, Scattering (SS) 2/3 degree, Receiving 0.8 mm (RS)
Measurement step width: 0.02 degree as 2θ
Scanning speed: 2 degrees per one minute
Rotation speed of the sample table: 30 rpm

The θ phase ratio was obtained from the intensities of the θ phase (102) plane and the γ phase (330) plane in the diffraction peak graph (for example, FIG. 2) obtained in the above-described conditions. Specifically, the θ phase ratio was obtained from the intensity ratio by using the formula shown below.

$$\theta \text{ phase ratio} = I_{obs}(\theta \text{ phase})/I_{obs}(\gamma \text{ phase})$$

$I_{obs}(\theta \text{ phase})$ was the measure peak intensity of the θ phase (102) plane and $I_{obs}(\gamma \text{ phase})$ was the measure peak intensity of the γ phase (330) plane.

The measurement results are shown in the column "θ phase ratio" in Table 4.

[Observation of the structure of the target]

On the sputtering targets of the above-described Examples 1-23 of the present invention and Comparative Examples 1 and 3, the structures of the targets were observed from the images of the compositional images (COMPO images) obtained by EPMA. The structure in which the θ phases were dispersed in the γ phase was graded as "A." The structure made of the single phase of the γ phase was graded as "B." The results are shown in the column "Structure of the target" in Table 4.

[Evaluation of target workability]

As evaluation of target workability on the sputtering targets of the above-described Examples 1-23 of the present invention and Comparative Examples 1 and 3, occurrence of chipping in cutting and the target surface roughness were measured.

[Measurement of occurrence of chipping in cutting]

The produced sputtering targets were machined on a lathe. Then, existence or non-existence of chipping (cracking or fracturing) was measured. In addition, the target surface roughness (Ra: arithmetic average roughness) after machining was measured. The conditions for machining on the lathe were that: 100 rpm of the rotation speed; 0.7 mm of the depth of cut; and 0.097 mm/rev of the feed. As the insert, commercially available inserts made of cemented carbide material were used.

Measurement results are shown in the column "Chipping in cutting" in Table 4. In the column in Table 4, it was graded as "S (Small)" when the maximum chipping size was 0.3 mm or less. It was graded as "M (Medium)" when the maximum chipping size exceeded 0.3 mm and 0.5 mm or less. It was graded as "L (Large)" when the maximum chipping size exceeded 0.5 mm. It was regarded as a good workability when the maximum chipping size was 0.5 mm or less.

[Measurement of the surface roughness]

The target surface roughness (Ra: arithmetic average roughness) after machining was measured by the surface roughness measuring instrument (Model: Surf Test SV-3000H4, manufactured by Mitsutoyo Co. Ltd.) after machining the produced sputtering targets on a lathe. In this measurement, measurement was performed using a needle with the stylus tip radius curvature of 2 μm and the stylus tip angle of 60° on a straight line orthogonal to the processing mark lines according to JIS B 0651:2001

The measurement results are shown in the column "Surface roughness (μm)"

[Table 4]

| | Characteristics of the target | | | | | | |
|---|---|---|---|---|---|---|---|
| | Density (g/cm³) | Ave. crystal grain size of the γ phase (μm) | Ave. crystal grain size of the θ phase (μm) | θ phase ratio | Structure of the target | Chipping in cutting | Surface roughness Ra (μm) |
| Ex. 1 | 7.21 | 5.1 | 9.5 | 0.83 | A | S | 0.9 |
| Ex. 2 | 7.52 | 12.4 | 25.2 | 0.18 | A | M | 1.2 |
| Ex. 3 | 7.10 | 4.3 | 8.2 | 1.54 | A | S | 0.7 |
| Ex. 4 | 7.66 | 6.5 | 13.7 | 0.03 | A | M | 1.4 |
| Ex. 5 | 6.72 | 8.5 | 17.1 | 9.98 | A | S | 0.6 |

(continued)

| | | Characteristics of the target | | | | | |
|---|---|---|---|---|---|---|---|
| | | Density (g/cm$^3$) | Ave. crystal grain size of the γ phase (μm) | Ave. crystal grain size of the θ phase (μm) | θ phase ratio | Structure of the target | Chipping in cutting | Surface roughness Ra (μm) |
| Ex. 6 | | 7.03 | 4.1 | 7.5 | 1.48 | A | S | 0.8 |
| Ex. 7 | | 7.11 | 6.2 | 11.6 | 0.81 | A | S | 1.0 |
| Ex. 8 | | 7.41 | 12.0 | 24.7 | 0.17 | A | M | 1.4 |
| Ex. 9 | | 6.99 | 44.7 | 90.7 | 0.70 | A | M | 1.1 |
| Ex. 10 | | 7.89 | 28.7 | 26.8 | 0.07 | A | M | 1.2 |
| Ex. 11 | | 7.37 | 26.3 | 25.7 | 1.20 | A | S | 0.9 |
| Ex. 12 | | 7.39 | 20.9 | 4.7 | 1.10 | A | S | 0.7 |
| Ex. 13 | | 7.30 | 21.4 | 105.7 | 1.05 | A | M | 1.0 |
| Ex. 14 | | 7.01 | 47.2 | 74.2 | 0.79 | A | S | 0.9 |
| Ex. 15 | | 7.03 | 248.0 | 498.4 | 0.70 | A | M | 1.6 |
| Ex. 16 | | 7.27 | 34.7 | 31.5 | 0.11 | A | M | 1.5 |
| Ex. 17 | | 7.10 | 16.5 | 17.5 | 1.22 | A | S | 1.2 |
| Ex. 18 | | 6.98 | 44.2 | 71.2 | 0.79 | A | S | 1.3 |
| Ex. 19 | | 7.01 | 4.5 | 8.4 | 1.43 | A | S | 0.9 |
| Ex. 20 | | 7.12 | 43.2 | 98.4 | 0.73 | A | M | 1.3 |
| Ex. 21 | | 6.70 | 4.4 | 9.7 | 1.50 | A | S | 1.0 |
| Ex. 22 | | 7.14 | 4.9 | 10.5 | 0.84 | A | S | 0.9 |
| Ex. 23 | | 7.11 | 40.6 | 86.4 | 0.70 | A | M | 1.1 |
| C. Ex. 1 | | 8.31 | 5.6 | - | 0.00 | B | L | 2.3 |
| C. Ex. 2 | Ga was melted out in cutting and cracking occurred | | | | | | | |

(continued)

| | Characteristics of the target | | | | | | |
|---|---|---|---|---|---|---|---|
| | Density (g/cm$^3$) | Ave. crystal grain size of the $\gamma$ phase ($\mu$m) | Ave. crystal grain size of the $\theta$ phase ($\mu$m) | $\theta$ phase ratio | Structure of the target | Chipping in cutting | Surface roughness Ra ($\mu$m) |
| C. Ex. 3 | 7.52 | 17.4 | - | 0.00 | B | L | 3.3 |
| C. Ex. 4 | $\theta$ phase was melted out in sintering and the sintered material was not formed properly | | | | | | |

According to the results shown in Table 4, it was confirmed that the average grain size of the $\gamma$ phases was 50.0 $\mu$m or less and small in any one of Examples 1-23 of the present invention. In addition, in the X-ray diffraction analysis, the two phases of the $\gamma$ phase and the $\theta$ phase were observed. In addition, it was confirmed that the $\theta$ phase ratio was 10.0 or less. In addition, good results were obtained regarding to chipping in cutting in these Examples of the present invention. Thus, improvement of workability was confirmed.

Contrary to that, in Comparative Example 1, which was the case where the raw material powder A was the raw material powder, the Ga component was less; and hot pressing was performed in an excessively high temperature deviated from the temperature range in the method of producing the sputtering target of the present invention. Therefore, the $\theta$ phase was not formed; the structure of the target became the single phase of the $\gamma$ phase; and chipping occurred in cutting. In addition, in Comparative Example 2, the Ga content was extensive deviating from the composition range of the sputtering target and the method of producing the sputtering target of the present invention. Thus Ga was melted out in machining; and cracking of the target occurred. In Comparative Example 3, the mixing ratio of the raw material powder B made of the single phase of the $\gamma$ phase was extensive. Thus, even if the raw material powder A made of the $\theta$ phase was used, the $\theta$ phase was not formed; the structure of the target became the single phase of the $\gamma$ phase; and chipping occurred in cutting. In Comparative Example 4, the $\theta$ phase was melted out in sintering; and the sintered material was not formed properly. Thus, the sputtering target could not be produced. Thus, in any one of Comparative Examples, workability was inferior.

As can be seen from the results described above, it was confirmed that: the Ga content was in the range of 30.0-67.0 atomic%; the both of the diffraction peaks attributed to the $\gamma$ and $\theta$ phases of the Cu-Ga alloy were observed when it was sintered at the temperature of 150-400°C; and the ratio of the intensity of the main peak among diffraction peaks attributed to the $\theta$ phases to the intensity of the main peak among diffraction peaks attributed to the $\gamma$ phases (the $\theta$ phase ratio) was in the range of 0.01-10.0 in the sputtering target of the present invention. For example, based on the photographs of the EPMA images shown in FIG. 3 and the graph of the XRD distraction analysis results shown in FIG. 2, it was confirmed that the structure, in which the $\theta$ phases containing a relatively high Ga content were dispersed in the matrix of the $\gamma$ phases of the sintered material of the Cu-Ga alloy, was obtained.

Therefore, on the sputtering target of the present invention, it was demonstrated that occurrence of chipping (cracking, fracturing) in cutting could be suppressed by dispersing the $\theta$ phases in the matrix of the $\gamma$ phases of the sintered material of the Cu-Ga alloy.

It is preferable that the surface roughness is set to 1.5 $\mu$m or less in the sputtering target of the present invention. In addition, it is preferable that the electrical resistance is set to $1 \times 10^{-4} \Omega \cdot$cm or less in the sputtering target of the present invention. In addition, it is preferable that the content of metal-based impurities is set to 0.1 atomic% or less in the sputtering target of the present invention. In addition, it is preferable that the transverse strength is set to 150 MPa or more in the sputtering target of the present invention. Each of Examples of the present invention satisfies all of these conditions.

The scope of the present invention is not limited by the descriptions of the above-described embodiment and Examples. Thus, the present invention can be subjected to varieties of modifications without deviating from the scope of the present invention.

For example, the sputtering targets in the embodiments of the present invention and Examples of the present invention are in flat-plate shape. However, it can be a sputtering target in a cylindrical shape.

INDUSTRIAL APPLICABILITY

A highly workable sputtering target for forming the CIGS thin film can be provided, and it is useful for producing high-performance solar cells efficiently.

REFERENCE SIGNS LIST

A:    θ phase
B:    γ phase

**Claims**

1.  A sputtering target having a component composition comprising: 30.0-67.0 atomic% of Ga; and the Cu balance containing inevitable impurities, wherein
    the sputtering target is a sintered material having a structure in which θ phases made of Cu-Ga alloy are dispersed in a matrix of the γ phases made of Cu-Ga alloy.

2.  The sputtering target according to Claim 1, wherein an average crystal grain size of the γ phases is 5.0-50.0 μm.

3.  The sputtering target according to Claim 1, wherein an average crystal grain size of the θ phases is 5.0-100.0 μm.

4.  The sputtering target according to any one of Claims 1 to 3, wherein a ratio of an intensity of a main peak among diffraction peaks attributed to the θ phases to an intensity of a main peak among diffraction peaks attributed to the γ phases is 0.01-10.0.

5.  The sputtering target according to any one of Claims 1 to 4, further comprising Na in a range of 0.05-15 atomic%.

6.  The sputtering target according to Claim 5, wherein the Na is included at least in a form of a Na compound selected from: sodium fluoride; sodium sulfide; and sodium selenide.

7.  A method of producing a sputtering target, the method comprising the step of producing a sintered material by sintering a powder, which is a Cu-Ga alloy powder including 40.0-67.0 atomic% of Ga and the Cu balance containing inevitable impurities; and a ratio of an intensity of a main peak among diffraction peaks attributed to θ phases to an intensity of a main peak among diffraction peaks attributed to γ phases, both of which are obtained from an X-ray diffraction pattern, is 0.01-10.0, in non-oxidizing atmosphere or reducing atmosphere: at a sintering temperature of 254°C or more and 450°C or less in a case where the ratio of main peaks is 0.5 or less; or at a sintering temperature lower than 254°C in a case where the ratio of main peaks is more than 0.5.

8.  A method of producing a sputtering target, the method comprising the step of producing a sintered material by sintering a mixed powder in non-oxidizing atmosphere or reducing atmosphere at a temperature of 150-400°C, a raw material powder, which is made of a γ phase of Cu-Ga alloy, and a raw material powder, which is made of a θ phase of Cu-Ga alloy, being mixed in the mixed powder; a mixing ratio of the raw material powder made of the θ phase being 35% or less; the mixed powder having a component composition including 30.0-42.6 atomic% of Ga, the Cu balance containing inevitable impurities; each of the γ phase and the θ phase being represented by a composition formula $CU_{1-x}Ga_x$; x being 0.295-0.426 in the γ phase; and x being 0.646-0.667 in the θ phase.

# FIG. 1

| Cu-Ga | |
|---|---|
| Phase | Composition, at.% Ga |
| (Cu) | 0 to 20.6 |
| β | 19.3 to 27.45 |
| ζ | 20.5 to 22.5 |
| ζ' | 21.0 to 22.4 |
| γ | 29.5 to 34.7 |
| $\gamma_1$ | 29.8 to 37.6 |
| $\gamma_2$ | 33.9 to 37.7 |
| $\gamma_3$ | 37.5 to 42.6 |
| θ | 64.6 to 66.7 |
| (Ga) | 100 |

P.R. Subramanian and D.E.
P.R. Subramanian,D.J. Cha
OH,174–184(1994)

## FIG. 2

[CUGA32-1143 80.raw]

γ phase (330) peak

θ phase (201) peak

71-0458>Copper Gallium-Cu9Ga4

25-0275>Copper Gallium-CuGa2

INTENSITY (Counts)

θ (deg)

FIG. 3

θ phase (A)    γ phase (B)

# FIG. 4

[CU35GA-650-2#.raw]

71-0458>Copper Gallium-Cu9Ga4

θ (deg)

FIG. 5

## INTERNATIONAL SEARCH REPORT

International application No.

PCT/JP2015/076515

### A. CLASSIFICATION OF SUBJECT MATTER

*C23C14/34*(2006.01)i, *B22F1/00*(2006.01)i, *C22C9/00*(2006.01)i, *C22C28/00* (2006.01)i, *C22C32/00*(2006.01)i

According to International Patent Classification (IPC) or to both national classification and IPC

### B. FIELDS SEARCHED

Minimum documentation searched (classification system followed by classification symbols)
C23C14/00-14/58, B22F1/00, C22C9/00, C22C28/00, C22C32/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)
JSTPlus(JDreamIII)

### C. DOCUMENTS CONSIDERED TO BE RELEVANT

| Category* | Citation of document, with indication, where appropriate, of the relevant passages | Relevant to claim No. |
|---|---|---|
| X<br>Y<br>A | WO 2012/098722 A1  (JX Nippon Mining & Metals Corp.),<br>26 July 2012 (26.07.2012),<br>paragraphs [0010] to [0048]; fig. 1<br>& US 2013/0319527 A1<br>paragraphs [0016] to [0074]; fig. 1<br>& EP 2666884 A1          & KR 10-2013-0118345 A<br>& TW 201231701 A | 1-4,7<br>5,6<br>8 |
| Y | WO 2011/055537 A1  (Mitsubishi Materials Corp.),<br>12 May 2011 (12.05.2011),<br>paragraphs [0021] to [0035]<br>& US 2012/0217157 A1<br>paragraphs [0037] to [0061]<br>& JP 2011-117077 A        & EP 2402482 A1<br>& KR 10-2011-0113213 A   & CN 102395702 A<br>& TW 201126002 A | 5,6 |

☒ Further documents are listed in the continuation of Box C.    ☐ See patent family annex.

| | |
|---|---|
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 23 October 2015 (23.10.15) | 02 November 2015 (02.11.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (July 2009)

**INTERNATIONAL SEARCH REPORT**

International application No.

PCT/JP2015/076515

C (Continuation). DOCUMENTS CONSIDERED TO BE RELEVANT

| Category* | Citation of document, with indication, where appropriate, of the relevant passages | Relevant to claim No. |
|---|---|---|
| A | JP 2008-138232 A (Mitsubishi Materials Corp.), 19 June 2008 (19.06.2008), paragraphs [0004] to [0014] (Family: none) | 1-8 |
| A | JP 2011-149039 A (Sanyo Special Steel Co., Ltd.), 04 August 2011 (04.08.2011), paragraphs [0007] to [0025] (Family: none) | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014192151 A
- JP 2015181053 A
- JP H10135495 A
- JP 2010280944 A
- JP 2011241452 A

**Non-patent literature cited in the description**

- **P. R. SUBRAMANIAN ; D. E. LAUGHLIN.** Binary Alloy Phase Diagrams. ASM International(R), 1990, 1410
- Binary Alloy Phase Diagrams